(19) Europäisches Patentamt
European Patent Office
Office européen des brevets

(11) **EP 2 347 892 A2**

(12) # EUROPÄISCHE PATENTANMELDUNG

(43) Veröffentlichungstag:
**27.07.2011 Patentblatt 2011/30**

(21) Anmeldenummer: **11157510.6**

(22) Anmeldetag: **14.03.2007**

(51) Int Cl.:
**B29D 11/00** *(2006.01)*    **B29C 39/14** *(2006.01)*
**B29C 39/18** *(2006.01)*    **G02B 5/18** *(2006.01)*
**G03F 7/00** *(2006.01)*    **G03F 7/20** *(2006.01)*

(84) Benannte Vertragsstaaten:
**AT BE BG CH CY CZ DE DK EE ES FI FR GB GR HU IE IS IT LI LT LU LV MC MT NL PL PT RO SE SI SK TR**
Benannte Erstreckungsstaaten:
**AL BA HR MK RS**

(30) Priorität: **15.03.2006 DE 102006011949**

(62) Dokumentnummer(n) der früheren Anmeldung(en) nach Art. 76 EPÜ:
**07723266.8 / 1 993 816**

(71) Anmelder: **EPG (Engineered nanoProducts Germany) AG**
**64347 Griesheim (DE)**

(72) Erfinder:
• **Mennig, Martin**
  **66287, Fischbach (DE)**
• **Oliveira, Peter**
  **66111 Saarbrücken (DE)**

(74) Vertreter: **Barz, Peter**
**Meissner Bolte**
**Widenmayerstrasse 48**
**80538 München (DE)**

Bemerkungen:
Diese Anmeldung ist am 09-03-2011 als Teilanmeldung zu der unter INID-Code 62 erwähnten Anmeldung eingereicht worden.

(54) **Verfahren zur herstellung von defektfreien Lichtlenkelementen grosser Breite, Vorrichtung zur Herstellung und diffraktives Lichtlenkelement**

(57) Verfahren zur Herstellung eines diffraktiven Lichtlenkelements durch ein kontinuierliches, einstufiges Rolle-zu-Rolle-Verfahren, das folgende Schritte umfasst: a) Auftragen einer photoempfindlichen Beschichtungszusammensetzung auf eine flexible Trägerbahn, b) Trocknen der Beschichtungszusammensetzung, c) Auflaminieren einer flexiblen Maske, d) Belichten der Beschichtungszusammensetzung durch die Maske, um durch die mustermäßige Belichtung einen Brechzahlgradienten in der Beschichtungszusammensetzung zu erzeugen, und e) vollflächiges Aushärten der Beschichtungszusammensetzung, um den Brechzahlgradienten zu fixieren, wobei die photoempfindliche Beschichtungszusammensetzung einen ein- oder mehrkernigen Metallkomplex mit einem Liganden mit photochemisch polymerisierbarer Gruppe als photopolymerisierbare Komponente umfasst.

**EP 2 347 892 A2**

**Beschreibung**

Die Erfindung betrifft ein Verfahren zur Herstellung diffraktiver Lichtlenkelemente, eine Vorrichtung zur Herstellung der diffraktiven Lichtlenkelemente und die damit erhältlichen Lichtlenkelemente

Lichtlenkelemente werden auch als Diffusoren bezeichnet. Unter Lichtlenkelementen bzw. Diffusoren versteht man Elemente insbesondere Folien mit Licht lenkenden Eigenschaften. Die einfachste Form von Diffusoren stellen Mattscheiben dar, die zwar eine streuende Wirkung haben, aber keine gerichtete Lenkung zulassen. Die Erzielung einer gerichtete Lichtlenkung ist jedoch für viele optische Anwendungen von hoher Bedeutung, da damit viele verschiedene Effekte erzielt werden können, z.B. Erhöhung der Lichtausbeute bei Displays, Einstellung des Streu- und Sichtwinkels von Displays, von Seitenlicht unabhängige Reflexion für Taglichtprojektion, Kontrasterhöhung und anderes mehr.

Für die Ausbildung von Lichtlenkeigenschaften wird ein Brechzahlgradient erzeugt.. Das Prinzip zur Erzeugung eines Brechzahlgradienten ist bekannt. Wie z.B. in US 5552261 und US 5529473 beschrieben, kann die Diffusion von Monomeren mit gegenüber der umgebenden flüssigen Matrix erhöhtem oder auch erniedrigtem Brechungsindex für die Erzeugung eines Brechzahlgradienten genutzt werden Der bei Photopolymeren bekannte "Colburn-Haines-Effekt" zur gerichteten Diffusion mit anschließender Polymerisierung in den mustermäßig belichteten Bereichen führt zu einer Erhöhung der Dichte und somit zu einer Erhöhung oder Erniedrigung des Brechwertes. Danach wird das Brechzahlgradientenprofil durch vollflächige Aushärtung fixiert.. Anstelle von einfachen organischen Monomeren wurden in der Folge auch photoempfindliche Komponenten anorganischer Natur eingesetzt, mit denen ein größerer Brechwertunterschied zu erreichen war.

Die Herstellung derartiger Lichtlenkelemente ist ebenfalls prinzipiell bekannt, etwa durch holographische Prozesse. Lichtlenkelemente können zum Beispiel durch Prägen von Oberflächenstrukturen mit lichtlenkender Wirkung oder durch punktförmige Belichtung (zum Beispiel mit Lochmasken) photoempfindficher Polymerfilme (Photopolymere) hergestellt werden

Beispielsweise beschreibt WO 03/058292 Verfahren zur Herstellung optischer Elemente mit Gradientenstruktur, bei dem in einer festen Matrix eingebettete nanoskalige Teilchen dadurch erhalten werden, dass man in einem Nanokompositmaterial aus einem härtbaren Matrixmaterial mit darin dispergierten Teilchen eine Potentialdifferenz erzeugt, so dass eine gerichtete Diffusion der nanoskaligen Teilchen unter Bildung des Konzentrationsgradienten erfolgt, und das den Konzentrationgradienten aufweisende Nanokompositmaterial härtet. Das Nanokompositmaterial kann ein photoempfindliches Material sein.

In der DE-A-10200760 wird ein Verfahren zur Herstellung einer Brechzahlgradientenfolie beschrieben, bei dem in einem polymerisierbaren, festen oder gelartigen Nanokompositmaterial ein Brechzahlgradient z.B. durch Lithographie oder lokale Belichtung erzeugt wird, der anschließend durch Aushärten fixiert wird.

In den Patentanmeldungen PCT/EP2005/013685 und PCT/EP2005/013683 des Anmelders werden Verfahren zur Herstellung optischer Komponenten mit Brechzahlgradienten beschrieben, bei denen der Brechzahlgradient in einem Hybridmaterial erzeugt wird, wobei das Hybridmaterial ein lösliches organisches Polymer und einen ein- oder mehrkernigen Metallkomplex mit photopolymerisierbaren oder thermisch polymerisierbaren Liganden umfasst. Durch lokale Bestrahlung oder Erwärmung des Hybridmaterials erfolgt die Ausbildung des Konzentrationsgradienten, der anschließend durch Härtung fixiert wird.

Aus dem vorstehend genannten Stand der Technik werden die Lichtlenkelemente nach einem zweistufigen Verfahren hergestellt In der DE-A-10200760 wird z.B eine photoempfindliche Zusammensetzung mit üblichen Beschichtungsverfahren auf einen Träger aufgebracht und getrocknet. Werden Kunststofffolien als Träger verwendet, wird der gebildete Verbund zum Schutz mit einer Abdeckfolie versehen und zur Lagerung aufgewickelt In einer zweiten Stufe erfolgt dann die Strukturierung der aufgebrachten photoempfindliche Zusammensetzung, wofür die Abdeckfolie gewöhnlich wieder entfernt werden muss.

Die Nachteile dieser zweistufigen Verfahren ergeben sich aus der Notwendigkeit, nach der Beschichtung nur sehr milde trocknen zu können, da in stärker verfestigten Schichten die Diffusion der höherbrechenden Monomeren oder der Nanopartikeln deutlich eingeschränkt ist und die Bildung einer Struktur wie einer holographischen Struktur im nachfolgenden mustermäßigen Belichtungsprozess praktisch unmöglich wird.. Dies wiederum bedingt eine sehr große mechanische Empfindlichkeit der aufgetragenen Schicht sowie die Neigung zum Verkleben mit der Maske Beide Effekte verursachen sehr hohe Defektraten in den Diffusorschichten, die für viele Anwendungen nicht tolerierbar sind Hinzu kommt der Umstand, dass jeder Prozessschritt, z.B. das Aufrollen und wieder Abrollen sowie dazugehörige Transportprozesse, die Fehlerquote weiter erhöht Außerdem ist die derzeitige Technologie auf Folienbreiten von maximal 60 cm beschränkt.. Im einzelnen ergeben sich insbesondere folgende Nachteile nach dem Stand der Technik:

1 Das im ersten Verfahrensschritt hergestellte Sandwich ist verfahrensbedingt sehr weich und fließfähig und gegen mechanische Belastung sehr empfindlich Durch das mehrfache Handling kommt es zwangsläufig zu mechanischen Belastungen und diese mechanischen Belastungen können zu minimalen Deformationen in der Oberfläche führen, die durch den anschließenden zweiten Schritt (Belichtung) optisch deutlich verstärkt werden.. Dies beruht auf der Tatsache, dass sich die beim Belichten erzeugten sogenannten "Lightpipes" entlang der Bestrahlungsrichtung ausbilden. Wenn also im zu belichtenden Sandwich Unebenheiten, wie kleine Dellen, Buckel, Wülste oder Riefen, die hier im folgenden als Mikrodefekte bezeichnet werden, vorhanden sind, so wird das photoempfindliche Material in der Umgebung dieser Mikrodefekte unter sehr unterschiedlichen Winkeln bestrahlt, was zu einer makroskopisch sichtbaren Störung der Parallelität der Lightpipes und somit zu makroskopisch deutlich sichtbaren Störungen im optischen Erscheinungsbild bzw. in der optischen Wirkung des gesamten Diffusors führt Solche Diffusoren sind vor allem für die Anwendung im Displaybereich ungeeignet

2 Das zweistufige Verfahren erfordert Lagerzeiten zwischen dem ersten und dem zweiten Verfahrensschritt Während dieser Lagerung kann es zu Alterungsprozessen im lichtempfindlichen Material kommen, die eine reproduzierbare Diffusorherstellung verhindern Außerdem führt die Lagerung des Sandwichmaterials im aufgewickelten Zustand durch unterschiedliche Drücke im Inneren und Äußeren der Sandwichrolle sowie durch den Schwerkrafteinfluss zu periodisch auftretenden Schichtdickenschwankungen, die zu deutlich sichtbaren periodischen Schwankungen der optischen Wirkung der daraus hergestellten Diffusorfolie führen, da es sich bei der Lightpipe-Struktur um Volumenphasenhologramme handelt, deren Wirkung (Beugungswirkungsgrad) stark von der Dicke abhängt Auch dies sind makroskopische Defekte, die einer Anwendung der Diffusoren, insbesondere im Displaybereich, entgegenstehen.

3 Für großformatige Anwendungen von Diffusoren, wie z.B. bei Projektionsleinwänden oder großformatigen LCD-TV-Displays, ist es erforderlich, zwei oder mehr Diffusorfolien in der Längsrichtung so zusammenzufügen, dass keine Naht sichtbar ist Dies liegt daran, weil die zur Belichtung erforderliche Optik in der Breite aus technischen und auch aus Kostengründen nicht beliebig, z B auf 1,60 m, auf skalierbar ist Das nahtlose Zusammenfügen von zwei oder mehreren, in dem oben beschriebenen zweistufigen Verfahren hergestellten Diffusem durch verschiedene, im Stand der Technik bekannte Verfahren, ist in der für die o.g. Anwendungen erforderlichen Qualität aber nicht möglich.

4 Das zweistufige Verfahren ist aufgrund der zahlreichen Prozessschritte sehr teuer

5 Werden Breiten von über 50 bis 60 cm gefahren, so treten aufgrund der grundsätzlich nicht vermeidbaren Inhomogenitäten in Bezug auf Belichtung und Trocknung beziehungsweise Temperaturführung Verwerfungen mit gewellten bzw nicht planaren Rändern auf Diese Bereiche können für die oben beschriebenen möglichen Anwendungen nicht mehr genutzt werden. Größere Flächen sind nur durch Zusammenfügen kleinerer Teile möglich Zwar lässt sich dieses Problem bis zu einem gewissen Grad durch das Anbringen von schräg gestellten Laufrädern auf dem Folienrand reduzieren, insgesamt ist es aber nach dem Stand der Technik mit dem zweistufigen Verfahren nicht möglich, größere Breiten zu realisieren

Der vorliegenden Erfindung lag daher die Aufgabe zugrunde, ein Verfahren bereitzustellen, mit dem die oben beschriebenen makroskopischen Defekte von Lichtlenkelementen vermieden werden können und das eine Herstellung von Diffusoren mit großer Breite erlaubt, die die Breite verfügbarer Belichtungsoptiken deutlich übertrifft

Es wurde nun überraschenderweise festgestellt, dass diese Aufgabe durch ein Verfahren zur Herstellung von diffraktiven Lichtlenkelementen mit einem kontinuierlichen Rolle-zu-Rolfe-Verfahren gelöst werden kann Die diffraktiven Lichtlenkelemente umfassen optische und mikrooptische Lichtlenkelemente

Die Erfindung betrifft daher Verfahren zur Herstellung eines diffraktiven Lichtlenkelements, das folgende Schritte umfasst:

a) Auftragen einer photoempfindlichen Beschichtungszusammensetzung auf eine flexible Trägerbahn,
b) Trocknen der aufgetragenen Beschichtungszusammensetzung,
c) Auflaminieren einer flexiblen Maske auf die getrocknete Beschichtungszusammensetzung,
d) Belichten der Beschichtungszusammensetzung durch die Maske, um durch die mustermäßige Belichtung einen Brechzahlgradienten in der Beschichtungszusammensetzung zu erzeugen,
e) vollflächiges Aushärten der Beschichtungszusammensetzung, um den Brechzahlgradienten zu fixieren,

wobei die Schritte a) bis e) in dieser Reihenfolge in einem kontinuierlichen, einstufigen Rolle-zu-Rolle-Verfahren durchgeführt werden.

Für das erfindungsgemäße Verfahren erfolgte eine Neukonstruktion einer kontinuierlich arbeitenden, kombinierten Beschichtungs- und Belichtungsanlage. Die Erfindung betrifft daher ferner eine Vorrichtung, mit der das erfindungsgemäße Verfahren durchgeführt werden kann, d h eine Vorrichtung zur Herstellung eines diffraktiven Lichtlenkelements in einem kontinuierlichen, einstufigen Rolle-zu-Rolle-Verfahren, umfassend

a) eine Auftrageinrichtung zum Auftragen einer photoempfindlichen Beschichtungszusammensetzung auf eine flexible Trägerbahn,

b) eine Trocknungseinrichtung zum Trocknen der aufgetragenen Beschichtungszusammensetzung,

c) eine Laminierungseinrichtung zum Auflaminieren einer flexiblen Maske auf die getrocknete Beschichtungszusammensetzung,

d) eine Belichtungseinrichtung zum Belichten der getrockneten Beschichtungszusammensetzung durch die Maske,

e) eine Härtungseinrichtung zum vollflächigen Aushärten der Beschichtungszusammensetzung,

wobei die Einrichtungen so gestaltet sind, dass eine Trägerbahn zur Durchführung des jeweiligen Verfahrensschritts kontinuierlich zu den Einrichtungen a) bis e) in dieser Reihenfolge transportiert werden kann.

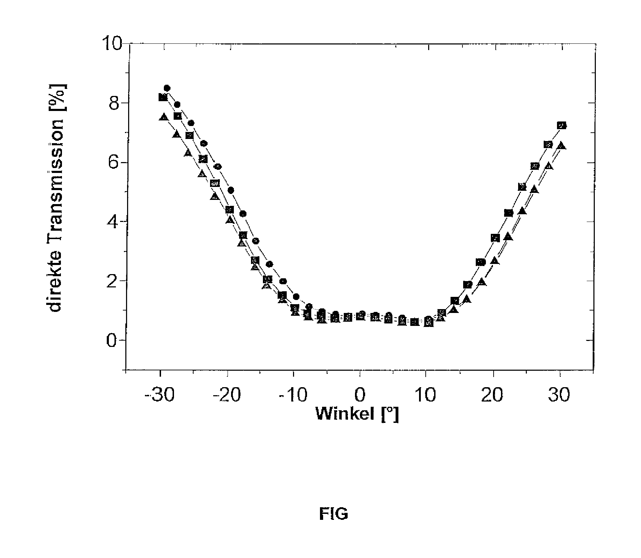

Die Figur zeigt die Transmission in Abhängigkeit vom Winkel gemessen an drei verschiedenen Positionen bei einem erfindungsgemäßen optischen Lichtlenkelement

Im Gegensatz zum Stand der Technik wird nach der Erfindung nach einem kontinuierlichen Auflaminieren einer Maske im Anschluss an den Vortrocknungsprozess der Belichtungsprozess des Sandwiches "Inline" durchgeführt. Die Maske kann nach der Belichtung sofort anschließend kontinuierlich und wiederum Inline entfernt werden. Dadurch kann der gesamte Prozess innerhalb einer eingehausten Beschichtungs-, Laminierungs- und Belichtungsanlage unter Reinraumbedingungen durchgeführt werden. Durch das erfindungsgemäße Verfahren werden viele Handhabungsvorgänge, wie Auf- und Abwickelprozesse oder Transportprozesse, überflüssig, die bislang nach dem Stand der Technik notwendig und Quellen für Defekte im herzustellenden optischen Element waren

Zwar werden dadurch Defektursachen, wie Auf- und Abwickeln und Transport, verringert, es bleibt aber eine Verklebungsproblematik, die sich durch die Laminierung und die bevorzugte anschließende Delaminierung der Maske ergibt Trotz dieser Problematik wurde nun überraschenderweise festgestellt, dass die Anzahl der Defekte um nahezu zwei Größenordnungen kleiner ist als bei den Verfahren nach dem Stand der Technik. Im Anschluss an die Delaminierung kann der delaminierte (maskenfreie) Film erfindungsgemäß problemlos voll ausgehärtet werden, so dass er mechanisch unempfindlich wird Insgesamt zeichnet sich das neue Verfahren durch eine außerordentlich hohe Defektfreiheit aus

Zur Vermeidung gewellter Ränder bei der Härtung/Trocknung kann die Vorrichtung nach dem Stand der Technik bekannte schräg gestellte, nach außen ziehende Laufrollen umfassen, die auf die Trägerbahn einwirken. Sie sorgen für eine Spannung an dem noch weichen Film nach außen Mit dieser Anordnung ist es nun überraschenderweise möglich, nahezu jede beliebige Folienbreite zu fertigen, ohne dass das Phänomen des Wellens auftritt. Damit ist es ohne weiteres möglich, mikrooptische Lichtlenkelemente mit Bandbreiten von 1,60 m und mehr zu erzielen.

Das Herstellungsverfahren der Erfindung ist ein kontinuierliches, einstufiges Rolle-ru Rolle-Verfahren.. Das Rolle-zu-Rolle-Verfahren ist eine allgemein übliche, dem Fachmann bekannte Technik, bei der ein flexibles Material wie eine Folie von einer Rolle abgewickelt und zu einer anderen Rolle transportiert wird, auf die es wieder aufgewickelt wird, wobei das Material während des Transports zur zweiten Rolle einem oder mehreren Behandlungsschritten unterworfen wird. Insbesondere werden die Schritte a) bis e) an dem flexiblen Material einstufig ausgeführt, ohne dass es zwischendurch wieder auf eine Zwischenrolle aufgerollt oder gegebenenfalls gelagert wird.

Die Herstellung des diffraktiven Lichtlenkelements wird kontinuierlich durchgeführt. Dies ist auch insofern überraschend, da die Herstellung des Lichtlenkelements unterschiedliche Verfahrensschritte, wie einen Beschichtungsschritt und einen mustermäßigen Belichtungsschritt umfasst, die ganz anderen Bedingungen unterworfen sind. So hatten die verschiedenen Behandlungsschritte in der üblichen Praxis einen unterschiedlichen Zeitbedarf.

Als flexible Trägerbahn kommen alle für diesen Zweck geeigneten Materialien in Betracht Bevorzugt handelt es sich um eine übliche Trägerfolie Als Trägerbahn oder Trägerfolie können, je nach vorgesehener Anwendung des Lichtlenkelements, Bahnen oder Folien mit permanenter oder temporärer Haftung an das herzustellende Lichtlenkelement eingesetzt werden Bei temporärer Haftung wird die Trägerbahn anschließend entfernt, so dass eine flexible Bahn oder Folie des Lichtlenkelements ohne Trägerbahn erhalten werden kann. Selbstverständlich können die Trägerbahnen eine übliche Vorbehandlung aufweisen, z.B. eine Antiblockbehandlung oder eine Koronabehandfung.

Die Trägerbahnen können transparent oder nicht transparent sein. Beispiele für Trägerbahnen sind Kunststofffolien, z.B. aus Polyethylen, Polypropylen, Polycarbonat, Polyester und Triacetat, bevorzugt aus Polyester, wie Polyethylenterephthalat (PET), oder Triacetat (TAC), Metallfolien oder metallisierte Folien Ein typisches Handelsprodukt ist z.B. Melinex®-Folie, eine Polyesterfolie. Die Trägerbahn befindet sich insbesondere auf einer Rolle, von der sie zur Durchführung des Verfahrens abgewickelt wird.

Im ersten Schritt wird eine photoempfindliche Beschichtungszusammensetzung, die bevorzugt flüssig ist, auf die flexible Trägerbahn aufgetragen. In der erfindunggemäßen Vorrichtung ist hierfür im ersten Teil der Anlage eine Auftrageinrichtung vorgesehen. Eine geeignete flexible Trägerbahn wird dort mit dem photoempfindlichen Material beschichtet Als Beschichtungsverfahren können alle aus dem Stand der Technik bekannten Verfahren benutzt werden, z.B. Walzenauftrag. Besonders geeignet sind solche Verfahren, die eine langsame Vorschubgeschwindigkeit ermöglichen, wie z. B. Spiral- oder Messerrakeln oder auch Gießverfahren wie Foliengießen oder Beschichten mit einer Breitschlitzdüse (slot coating) Das Beschichtungsverfahren eignet sich bevorzugt zur Bereitstellung der gewünschten Trok-

kenschichtdicke Die Auftragmenge wird so gewählt, dass die gewünschte Trockenschichtdicke der Beschichtungszusammensetzung erreicht wird Die Trockenschichtdicke kann in breiten Bereichen variieren, im allgemeinen liegt sie z.B. bei 10 bis 250 $\mu$m, bevorzugt bei 10 bis 150 $\mu$m und besonders bevorzugt bei 40 bis 75 $\mu$m

Danach wird die aufgetragene Beschichtungszusammensetzung getrocknet. Die Trocknung erfolgt im allgemein soweit, dass die flexible Make auflaminiert werden kann Die Trocknung kann nach allen, dem Fachmann bekannten Verfahren durchgeführt werden, z.B durch Erwärmen und/oder mit einem Gasstrom Bevorzugt wird durch Erwärmen getrocknet. Bei der Trocknung wird das Lösungsmittel in der Beschichtungszusammensetzung ganz oder teilweise entfernt, beispielsweise auf einen Restanteil von 0 bis 20 Gew.-%. Die Vorrichtung umfasst für die Trocknung eine Trocknungseinrichtung, die vorzugsweise aus einem Ofen besteht Trocknungsbedingungen, wie Temperatur und Dauer, hängen voneinander, der verwendeten Beschichtungszusammensetzung und dem gewünschten Trocknungsgrad ab, die der Fachmann auf Basis der Erfindung in zweckmäßiger Weise auswählen kann.

Im Anschluss an die Beschichtungsstation durchläuft die beschichtete Trägerbahn daher vorzugsweise einen Ofen, in dem die im photoempfindlichen Material vorhandenen Lösungsmittel ganz oder teilweise entfernt werden, Die Länge des Ofens richtet sich nach der Verdampfungsrate dieser Lösungsmittel und der für die Belichtung (Schritt d)) erforderlichen Bahngeschwindigkeit Sie liegt im allgemeinen im Bereich zwischen 1 und 10 m, bevorzugt im Bereich zwischen 1,5 und 5 m und besonders bevorzugt zwischen 2 und 4 m

Im Anschluss daran wird für das Maskenbelichtungsverfahren die flexible Maske durch aus dem Stand der Technik bekannte Verfahren auflaminiert. Maskenbelichtungsverfahren und dafür einsetzbare Masken sind bekannt Als Maske können alle geeigneten üblichen Masken verwendet werden, deren Mikrostruktur für die Erzeugung des Lichtlenkelements mit den erforderlichen optischen Eigenschaften geeignet ist Typische Beispiele sind handelsübliche Fotomasken oder Lochmasken. Geeignet sind auch Masken, in denen Teilchen, die im Hinblick auf die Wellenlänge der zu erfolgenden Belichtung lichtundurchlässig sind, in einer lichtdurchlässigen Matrix, z.B. einem transparenten Polymer, die Struktur bilden. Die Struktur ergibt sich durch die homogene Verteilung der Teilchen in der Matrix und kann z.B durch die geeignete Wahl der Konzentration der Teilchen in der Matrix, ihrer Form und ihrer Größe entsprechend der gewünschten Struktur variiert werden.

Die Maske besitzt gemäß gängiger Praxis bei Maskenbelichtungsverfahren für mikrooptische Systeme Bereiche, die für das in Schritt d) verwendete Licht durchlässig sind, und Bereiche, die für das in Schritt d) verwendete Licht undurchlässig sind Die lichtdurchlässigen Bereiche und die lichtundurchlässigen Bereiche bilden entsprechend der gewünschten diffraktiven oder mikrooptischen Struktur im herzustellenden Element ein geeignetes Muster. Der Fachmann kann die für den jeweiligen Zweck geeignete Maske ohne weiteres auswählen. Es ist bevorzugt, dass die flexible Maske wieder von der Beschichtungszusammensetzung abgelöst werden kann, das heißt, die Maske kann reversibel auflaminiert werden

Die flexible Maske ist bevorzugt eine Maskenfolie. In einer bevorzugten Ausführungsform umfasst die Maske eine Trägerfolie, auf die ein Maskenfilm aufgebracht ist, der die Strukturierung, also die lichtdurchlässigen und lichtundurchlässigen Bereiche, bereitstellt und die eigentliche Maske darstellt. Der Film kann eine ablösbare oder nicht ablösbare Schicht auf der Trägerfolie sein Der Film kann zusammen mit der Trägerfolie einen Folienverbund aus der Trägerfolie und einer Maskenfolie bilden.

Die Maske kann auf einer Rolle aufgewickelt sein und zur Auflaminierung abgewickelt werden Zur Auflaminierung eignen sich alle dem Fachmann bekannten Techniken. Es kann z.B ein Prägekalander eingesetzt werden. Wenn eine flexible Maske verwendet wird, die eine Trägerfolie umfasst, wird vorzugsweise als nächstes die Trägerfolie des Maskenfilms durch eine geeignete Delaminierstation entfernt, um die maximale optische Qualität zu erzielen. Auf diese Weise wird ein Sandwich erhalten, der die Trägerbahn, die darauf aufgetragene Beschichtungszusammensetzung und die Maske umfasst, wobei von der Maske gegebenenfalls die Trägerfolie entfernt wurde.

Im nächsten Schritt wird die Beschichtungszusammensetzung durch die Maske belichtet. Dadurch erfolgt eine mustermäßige Belichtung der photoempfindlichen Beschichtungszusammensetzung. Auf diese Weise wird in der Beschichtungszusammensetzung ein Brechzahlgradient erzeugt, wie später erläutert Hierfür umfasst die erfindungsgemäße Vorrichtung eine geeignete Belichtungseinrichtung

Zur Belichtung können alle geeigneten Lichtquellen verwendet werden Ihre Auswahl richtet sich nach dem photoempfindlichen Material, z.B. nach den darin enthaltenen Photostartern und Sensibilisierungsmitteln, wenn vorhanden Die Belichtung kann senkrecht oder in einem bestimmten Neigungswinkel zur Trägerbahnebene erfolgen Es können mehrere Lichtquellen mit entsprechender Optik hintereinander geschaltet werden, wobei ihre Neigungswinkel gleich oder auch verschieden sein können Es kann z B Laserlicht, UV-Licht oder sichtbares Licht verwendet werden, wobei UV-Strahlung bevorzugt ist Bevorzugt wird mit parallelem Licht belichtet

Die Belichtung kann bei Raumtemperatur (23°C) durchgeführt werden. In einer bevorzugten Ausführungsform wird der Sandwich bei der mustermäßigen Belichtung einer Wärmebehandlung unterworfen, z.B. über 35°C. Für die Erwärmung eignet sich z.B. ein Heiztisch Der nach Schritt c) erhaltene Sandwich, von dem gegebenenfalls die Trägerfolie der Maske entfernt wurde, kann zweckmäßigerweise über einem Tisch, bevorzugt einem beheizbaren Tisch, belichtet werden. Die bei der mustermäßigen Belichtung verwendete Temperatur hängt wiederum von den zu erzielenden optischen Eigenschaften, wobei zu berücksichtigten ist, dass die Einstellung des Brechzahlgradientenprofils diffusionskontrolliert ist, sowie von der thermischen Beständigkeit der eingesetzten Werkstoffe, wie Trägerbahn, photoempfindliches Material und Maskenmaterial, ab Bevorzugt sind Temperaturen von Raumtemperatur bis 120 °C und besonders bevorzugt von 60 bis 80°C

Zur Planarisierung des Sandwich auf dem Heiztisch ist es zweckmäßig, wie oben beschrieben, Streckwalzen bzw. Spannwalzen am Rand einzusetzen. Vor dem Hintergrund, eine zusätzliche Möglichkeit zum Ausgleich von Spannungen im Material zu haben, kann ein zusätzlicher Temperprozess nach der Belichtung eingeschaltet werden. Solche Prozesse sind aus der Kunststoff- und Glastechnik bekannt; dabei wird eine Temperatur gewählt, die in der Nähe des jeweiligen Transformationsbereiches der betrachteten Werkstoffe liegt, im vorliegenden Falle z B bei Temperaturen von 60 °C bis 90 °C. Durch die mustermäßige Belichtung können sogenannte Lightpipes gebildet werden

Im Anschluss daran ist es bevorzugt, die flexible Maske durch ein dem Fachmann bekanntes Verfahren von der mustermäßig belichteten Beschichtungszusammensetzung abzulösen und gegebenenfalls aufzuwickeln Die Maske kann auch nach dem vollständigen Aushärten, aber noch im Rolle-zu-Rolle-Verfahren, abgezogen werden, d h vor dem Aufwickeln des hergestellten Lichtlenkelements auf die Rolle.

Im nächsten Prozessschritt wird die mustermäßig belichtete Beschichtungszusammensetzung vollflächig ausgehärtet. Dies kann durch Belichtung oder Wärmebehandlung erfolgen, wobei eine ganzflächige Aushärtung durch Belichtung bevorzugt ist. Bei ganzflächiger Aushärtung durch Erwärmen stört die Maske nicht, bei Belichtung kann dies z.B. von der Rückseite des Sandwich erfolgen, wenn die Trägerbahn für das eingesetzte Licht transparent ist, so das dies auch bei Anwesenheit der Maske durchgeführt werden kann. Wie gesagt ist die Ablösung der Maske vor der ganzflächigen Aushärtung aber bevorzugt. Die Beibehaltung kann z.B. zweckmäßig sein, damit die Maske beim späteren Aufwickeln des fertigen diffraktiven Elements als Schutzfolie dient..

Bei der vollflächigen Aushärtung wird der in Schritt d) gebildete Brechzahlgradient fixiert. Bei der bevorzugten Aushärtung durch Belichtung kann der Sandwich mit oder ohne Maske durch eine Flutbelichtung ganzflächig ausgehärtet und damit die durch die Maskenbelichtung erzeugte Brechzahlgradientenstruktur fixiert werden. Auch für die vollständige Aushärtung kann z.B. Laserlicht, UV-Licht oder sichtbares Licht verwendet werden. Die Wellenlänge des dafür verwendeten Lichts kann der zur Erzeugung der Brechzahlgradientenstruktur verwendeten Lichts entsprechen oder davon verschieden sein. Dies richtet sich wiederum zweckmäßigerweise nach Art und Anzahl der im photoempfindlichen Material vorhandenen Photostarter oder Sensibitisierungsmittel. Die Flutbelichtung kann bei transparenten Trägerfolien von unten (durch die Trägerfolie hindurch) oder auch von oben geschehen, insbesondere bei nicht transparenten Trägerfolien.

Zum Aufwickeln des so hergestellten diffraktiven Lichtlenkelements kann eine geeignete Trennfolie als Zwischenlage verwendet werden, die auf das Element aufgebracht wird. Dieser Schritt kann entfallen, wenn die Maske nach dem Belichten nicht entfernt wurde Eine solche Trennfolie oder Schutzfolie kann nach Bedarf zu einem späteren Zeitpunkt bei der Weiterverarbeitung des Lichtlenkelements wieder entfernt werden

Das Prinzip zur Herstellung von Brechzahlgradienten durch Verwendung von photoempfindlichen Beschichtungszusammensetzungen ist wie vorstehend erläutert bekannt und im Stand der Technik eingehend erläutert. Im erfindungsgemäßen Verfahren können als photoempfindliche Beschichtungszusammensetzungen die üblichen Zusammensetzungen aus dem Stand der Technik verwendet werden Die Beschichtungszusammensetzung umfasst insbesondere eine photopolymerisierbare Komponente in einem aushärtbaren Matrixmaterial, dessen Brechzahl sich von der der photopolymerisierbaren Komponente bzw. der photopolymerisierten Komponente unterscheidet Bei der photopolymerisierbaren Komponente handelt es sich in der Regel um eine Komponente mit höherer Brechzahl als das Matrixmaterial, wofür sich insbesondere Komponenten anorganischer Natur eignen, bevorzugt sind Ti-, Zr-, Nb-oder Ta-haltige Komponenten Die photopolymerisierbare Komponente wird bei der mustermäßigen Belichtung polymerisiert und es kommt zu der vorstehend erläuterten gerichteten Diffusion Dadurch wird ein Konzentrationsgradient und damit ein Brechzahlgradient in der Matrix erzeugt, der bei der anschließenden Härtung fixiert wird.

Als photopolymerisierbare Komponente eignen sich die im Stand der Technik verwendeten, wie z.B. ein- oder mehrkernige Metallkomplexe mit einem Liganden mit photochemisch polymerisierbarer Gruppe oder nanoskalige Teilchen, mit Oberflächengruppen mit photochemisch polymerisierbarer Gruppe, z.B mit einer mittleren Teilchengröße von 2 bis 200 nm. Die Liganden bzw. Oberflächengruppen sind in der Regel organische Natur, so dass auch anorganische photoempfindliche Komponenten organische Bestandteile umfasst. Als photopolymerisierbare Gruppen können alle dem Fachmann bekannte eingesetzt werden, z.B reaktive Doppelbindungen wie Vinyl oder (Meth)acryl

Als Matrixmaterial eignet sich das im Stand der Technik eingesetzte Material, wie z.B. organische Polymere, Oligomere oder Monomere und/oder gegebenenfalls organisch modifizierte anorganische Kondensate, z B Kondensate aus hydrolysierbaren Silanen. Das Matrixmaterial kann unter den Bedingungen von Schritt e) gehärtet werden. Die Beschichtungszusammensetzung kann ferner neben Lösungsmittel geeignete Zusätze enthalten, z.B. Weichmacher, thermische oder photochemische Polymerisations- bzw. Vernetzungsinitiatoren (Thermo- oder Photostarter), Sensibilisierungsmittel, Netzhilfsmittel, Adhäsionshilfsmittel, Antioxidationsmittel, Verlaufsmittel, Stabilisatoren, Farbstoffe, photochrome und thermochrome Verbindungen. Sensibilisierungsmittel oder Photostarter können dazu dienen, den für die Photopolymerisation geeigneten Wellenlängenbereich des Lichts zu variieren oder zu verbreitern. Weitere Einzelheiten zu den einsetzbaren Komponenten der Beschichtungszusammensetzungen können z.B. in den vorstehend diskutierten Anmeldungen WO 03/058292, DE-A-10200760, PCT/EP2005/013685 und PCT/EP2005/013683 entnommen werden, die hier unter Bezugnahme aufgenommen sind.

Eine photoempfindliche Beschichtungszusammensetzungen bedeutet, dass sie für die bei den Belichtungsschritten der Erfindung verwendete Strahlung empfindlich sind und bei Belichtung Härtungs- bzw. Polymerisationsreaktionen eingehen. Die Beschichtungszusammensetzung ist für den Auftrag vorzugsweise flüssig Nach der Trocknung ist sie dann vorzugsweise viskos, gelartig oder fest.

Bei der mustermäßigen Belichtung erfolgt die Strukturierung durch die Diffusion der photopolymerisierbaren Komponente, die in den durchstrahlten, das heißt von der Maske nicht abgedeckten Bereichen, fixiert werden und damit Zonen höheren Brechwertes bilden Der erhöhte Brechwert ergibt sich in der Regel daraus, dass die photopolymerisierbare oder die photopolymerisierte Komponente anorganischer Natur ist und in der Regel eine im Vergleich zur Polymermatrix deutlich erhöhte Brechzahl aufweist..

Die Struktur des erhaltenen Brechzahlgradienten ist beliebig und kann anhand der gewünschten Anwendung ausgewählt werden. Es kann jedes beliebige zwei- oder dreidimensionale Muster aus Bereichen mit höherer Brechzahl und Bereichen niedriger Brechzahl gebildet werden. Es kann sich z B um ein holographisches Profil handeln. Es können laterale, säulenförmige Brechzahlgradientenstrukturen mit vorzugsweise stochastisch verteilter lateraler Größenverteilung im sub-$\mu$m bis zum unteren $\mu$m-Bereich, die sogenannten Lightpipes, erhalten werden. Diese Lightpipes sind z.B. zueinander parallel ausgerichtet und stehen senkrecht (symmetrischer Diffusor) oder in einem bestimmten Winkel (asymmetrischer Diffusor) zur Folienebene In besonderen Fällen können zwei oder mehrere Scharen von Lightpipes erzeugt werden, die unter verschiedenen Winkeln (einschließlich 90°) zur Folienebene angeordnet sind.

Mit dem erfindungsgemäßen Verfahren sind im Vergleich zum Stand der Technik mikrooptische Lichtlenkelemente mit großer Breite herstellbar, die z.B. für großflächige Displayanwendungen, wie z.B. Projektionsleinwände, Projektions-TV oder LCD-TV, benötigt werden.

Beim zweistufigen Herstellungsverfahren nach dem Stand der Technik ist die maximal zugängliche Breite durch die Breite des zur Belichtung verwendeten Beleuchtungsfeldes limitiert.. Dieses kann man optisch nicht beliebig aufweiten, da sonst die für die Belichtung erforderliche Lichtintensität zu stark sinkt Ein Nebeneinanderschalten von mehreren Beleuchtungsfeldern in Folienrichtung ist aufgrund der unvermeidlichen Divergenz der Strahlen im Randbereich der Beleuchtungsfelder nicht möglich. Ein bogenweises Zusammenfügen von Diffusern ist technisch nicht nur sehr kompliziert, sondern im Vergleich zu einem kontinuierlichen Verfahren zu teuer

Mit dem erfindungsgemäßen einstufigen Herstellungsverfahren ist es nun erstmalig möglich, zwei oder mehrere mikrooptische Lichtlenkelemente bahnenweise nebeneinander sukzessive herzustellen. Dazu wird von der Trägerbahn zunächst nur ein Teilstück, z.B die halbe Bahnbreite, mit der photoempfindlichen Beschichtungszusammensetzung beschichtet und belichtet. Dazu wählt man vorzugsweise eine Trägerbahn, auf der das flüssige photoempfindliche Material so gut benetzt, dass die Schicht am Rand keilförmig verläuft. Nachdem der Diffusor auf die oben beschriebene Weise in diesem Teilabschnitt der Trägerbahn hergestellt wurde, wird der gleiche Prozess im nächsten Teilabschnitt wiederholt, wobei der Nahtbereich bevorzugt keilförmig überschichtet wird und die Beleuchtungseinrichtung entsprechend durch Parallelverschieben über dem neuen Teilstück justiert wird

Mit geeignet gewählten Parametern konnten insgesamt ca 20 Meter Ein-Schritt-Diffusor produziert werden, wie in dem Beispiel beschrieben.

Selbstverständlich kann die Vorrichtung auch geeignete übliche Einrichtungen zum Transportieren, Ab- oder Aufwickeln oder Führen von Bahnen, wie Rollen, Walzen, Bremsen usw, Antriebseinrichtungen, Steuerungseinrichtungen und Mess- und Kontrolleinrichtungen umfassen, oder solche Einrichtungen können an die Vorrichtung angebracht werden, wie sie für den Transport und die Behandlung von Bahnen bzw. Bändern üblich sind. So kann die Rolle mit der Trägerbahn am Anfang der Vorrichtung plaziert werden, um die Bahn zur Vorrichtung zu transportieren, und am Ende befindet sich eine zweite Rolle, auf die das hergestellte Produkt aufgewickelt wird. Die Rolle können gegebenenfalls auch an dafür vorgesehenen Stellen in die Vorrichtung montiert werden.

Durch Zerrung hervorgerufene Längsstreifen auf dem herzustellenden Lichtlenkelement können durch eine zweckmäßig eingestellte Bahnspannung für die Trägerbahn während des Herstellungsverfahrens vermieden werden. Besonders gute Ergebnisse konnten erzielt werden, wenn der Druck für die Bremse der Abwicklung auf etwa 2 bar eingestellt wurde. Eventuelle Rillenbildung auf der Maske nach der Laminierung konnte durch genaue Anpassung der Laufgeschwindigkeit des Prägekalanders für die Auflaminierung der Maske an die Bahngeschwindigkeit der Trägerbahn vermieden werden. Außerdem wurde festgestellt, dass auch kleinere Erschütterungen der Bahn, wie z B. Berührungen der Aufwicklung oder des Belichtungstisches, zu Fehlern in der Schicht führen

Durch das erfindungsgemäße Verfahren können diffraktive Lichtlenkelemenfie als flexible Bahnen, vorzugsweise in Form von Folien, in einem kontinuierlichen Rolle-zu-Rolle-Verfahren in einer Stufe hergestellt werden Dabei wird die Trägerbahn von einer Rolle abgewickelt, zu einer zweiten Rolle transportiert und dort wieder aufgewickelt, wobei die Bahn während des Transports dorthin nacheinander den beschriebenen Verfahrensschritten unterworfen wird. Ein kontinuierliches Verfahren erfordert eine konstante Bahngeschwindigkeit, d.h. die Trägerbahn wird mit gleichbleibender-Geschwindigkeit transportiert Überraschenderweise war es erfindungsgemäß möglich, geeignete Arbeitsschritte zu kombinieren und sie nacheinander in einem kontinuierlichen Durchgang durchzuführen. Die Bahngeschwindigkeit kann vom Fachmann in geeigneter Weise ausgewählt werden, das erfindungsgemäße Verfahren kann z.B. mit einer Bahngeschwindigkeit im Bereich von 0,05 bis 10 m/min, bevorzugt 0,1 bis 4 m/min, durchgeführt werden.. Die Bahngeschwindigkeit ist im Vergleich zu den bei Beschichtungsverfahren herkömmlicherweise verwendeten Geschwindigkeiten relativ niedrig, dennoch werden gleichwertige und sogar bessere Beschichtungsergebnisse erzielt. In dem erfindungsgemäßen kontinuierlichen Verfahren ist die Bahngeschwindigkeit für die Beschichtung und für die Belichtung (Strukturierung) identisch.

Die erfindungsgemäß erhaltenen Lichtlenkefemente können mit einem oder mehreren anderen Lichtlenkelementen kombiniert werden, indem man sie in der gewünschten Reihenfolge übereinanderlegt oder -schichtet. Die Lichtlenkelemente können auf übliche Weise miteinander verbunden werden, z.B. durch Kleben.. Das oder die anderen Lichtlenkelemente können jeweils herkömmliche sein oder bevorzugt ebenfalls nach dem erfindungsgemäßen Verfahren hergestellt sein. Mit einem solchen Zweischicht- oder Mehrschichtverbund können besondere optische Wirkungen erzielt werden. Wenn man z.B zwei asymmetrische Diffusoren ($\pm 30°$ $\pm 50°$) kombiniert, erhält man ein Lichtlenkelement mit hoher Transmission bei senkrechtem Lichteinfall und niedriger Transmission bei schrägem Lichteinfall

Durch das erfindungsgemäße Verfahren konnten mikrooptische Lichtlenkelemente hergestellt werden, die im Gegensatz zu den Elementen, die mit Verfahren nach dem Stand der Technik erhalten werden, praktisch frei von Einschlüssen oder Blasen waren Die hergestellten Bahnen können nach Bedarf in Stücke geeigneter Länge geschnitten werden Die Figur zeigt die Leistungsfähigkeit eines im Beispiel hergestellten Lichtlenkelements, im Hinblick auf die Transmission in Abhängigkeit vom Winkel gemessen an drei verschiedenen Positionen in Querrichtung (rechter Rand, Mitte, linker Rand).

Die Erfindung wird durch das folgende Beispiel erläutert

**Beispiel**

**1. Photoempfindliche Beschichtungszusammensetzung**

Herstellung Zr-Komplex (Zr/Methacrylsäure-Komplex; Zr/MAS)

Es wurden 187,2 g (0,40 Mol) Zr(OPr)$_4$ (82 % in Butanol) in einem 500 ml Dreihalskolben vorgelegt und im Eisbad gekühlt. Dazu wurden unter Rühren langsam 34,44 g (0,40 Mol) Methacrylsäure hinzugegeben. Anschließend wurde das Realtionsgemisch auf 25 °C erwärmt und für 15 Minuten gerührt.

Herstellung Polymerlösung

Zu 1000 g Butylacetat gab man 250 g PVAc-Pellets und rührte 16 h bei 80 °C. Nach Zugabe von 100 g Ebecryl® 150 (Methacrylat-modifiziertes Bisphenol A) rührte man weitere 10 min bei 25 °C, bis das Reaktionsgemisch klar wurde.. Anschließend wurden 150 g Ultramol M® (Adipinsäureester-Derivate) hinzugegeben und 20 min bei 25 °C gerührt.

Herstellung Beschichtungslösung

Danach gab man 22,27 g des hergestellten Zr/MAS unter Rühren langsam zur Polymerlösung, Nach vollständiger Zugabe rührte man 10 min lang bei 25°C. Nach dem Rühren wurden 031% Irgacure® 651 als Photostarter zugegeben

**2. Maske**

Die Maske wurde einige Stunden vor der Diffusorproduktion hergestellt. Hierzu kam eine Maskensuspension (AM315) mit einem Graphitanteil von 2,8 % im Feststoff bei einem Gesamtfeststoffgehalt von 6,3 % zum Einsatz. Als Trägerfolie zur Maskenherstellung wurde Meline® 400 mit einer Stärke von 75 $\mu$m und einer Breite von 356 mm verwendet Die Applikation erfolgte mit einem konventionellen Rakelkasten und Rakelmesser mit einem Spalt von 200 $\mu$m. Bei einer Bahngeschwindigkeit von 1 m/min und einer Ofentemperatur von 150°C wurde die mit der Suspension beschichtete Folie getrocknet, um die flexible Maske herzustellen.

**3. Trägerbahn**

Als Trägerbahn kam Mefinex®-Folie 400 mit einer Stärke von 50 $\mu$m und einer Breite von 540 mm zum Einsatz Diese Folie trägt auf der Außenseite eine Antiblock-Vorbehandlung. Der Auftrag der Beschichtungszusammensetzung erfolgte auf der unbehandelten Innenseite der Substratfolie.

### 4. Bahnlauf

Der Bahnfauf ist in vier Teilbereiche aufgeteilt.

a) Der Auftrag der Beschichtungszusammensetzung und die Trocknung der Schicht im Ofen. Das Auftragen des Sols erfolgte manuell mit einem Rakelkasten und einem Rakelmesser. Im anschließenden Durchlauf durch einen Umluftofen erfolgte die Trocknung der applizierten Schicht..

b) Im nächsten Teilbereich erfolgte die Laminierung Ein Walzensystem presst die Folie mit der Maske auf die getrocknete Photonanomerschicht. Die Maske bleibt auf dem Photonanomer kleben. Die Maskenfolie wird von dem Walzensystem abtransportiert

c) Den dritten Bereich stellt die Belichtung dar.. Zum Aushärten der laminierten Schichten stehen zwei UV Lampen der Firma Lot Oriel zu Verfügung Während der ersten Belichtung wurde die Folie über einen beheizten Tisch geführt und gleichzeitig belichtet.

d) Die zweite Belichtung erfolgt von der Rückseite, um Bereiche, welche zuvor eventuell nicht komplett gehärtet werden konnten, auszuhärten. Dieser Belichtungsschritt wird als Flood Cure bezeichnet Im letzten Teilbereich wurde auch die Maske delaminiert Hierzu wurde die Maske von Hand abgezogen

### 5. Durchführung

In der folgenden Tabelle sind Parameter für die Abwicklung und die Masterwalze angegeben:

| Nr. | Name | Wert |
|---|---|---|
| 1 | Beschichtete Folienseite | Innen |
| 2 | Druck der Bremse Abwickler | 2 bar |
| 3 | Leistung Korona | Aus |
| 4 | Ionisierstab ja/nein | Aus |
| 5 | Druck der Andruckwalze | Aus |
| 6 | Bahngeschwindigkeit | 0,31 m/min |

Der aufgeführte Druck der Bremse (Nr. 2) von 2 bar ist relativ hoch, damit die Bandspannung der Masterwalze ausreichend groß genug ist, um ein Auslaufen des Sols aus dem Rakelkasten zu verhindern. Normalerweise wird die dazu erforderliche Bremswirkung dadurch aufgebracht, dass die Folie mit einer Gummiwalze an die Masterwalze gepresst wird. Dies kann wegen der sehr hohen Abzugspannung dazu führen, dass in dieser Klemmung Falten eingezogen werden. Durch Verwendung einer dickeren Trägerbahn (z.B. mit 75 $\mu$m) kann dies vermieden werden..

In der folgenden Tabelle sind die Rakelparameter aufgelistet.

| Nr. | Name | Wert |
|---|---|---|
| 7 | Verwendetes Rakelmesser | Neu |
| 8 | Spalt Rakelmesser | 160 $\mu$m |
| 9 | Verwendeter Rakelkasten | 5 |
| 10 | Spalt Rakelkasten | 1 mm |
| 11 | Einfüllmethode | Manuell |
| 12 | Eingesetzte Lackmenge | 250 ml |

Der verwendet Rakelkasten hatte eine Breite von 26 cm. Für lange Beschichtungsläufe kann das Sol kontinuierlich aus einem Vorlaufgefäß, z.B. einem Tropftrichter, zudosiert werden.

Folgende Tabelle zeigt die verwendeten Ofenparameter

| Nr. | Name | Wert |
|---|---|---|
| 13 | Ofenklappe 1 | 9 |
| 14 | Ofenklappe 2 | 8 |
| 15 | Ofenklappe 3 | 8 |
| 16 | Ofenklappe 4 | 7 |
| 17 | Ofentemperatur | 80 °C |
| 18 | Umluftgeschwindigkeit | 6,3 m/s |

Die aufgeführten Ofenklappen (Position 13-16) regulieren die Strömung der Umluft innerhalb des Ofens. Zwei der Klappen sind für die Luftansaugung zuständig, die anderen beiden zur Luftverteilung

In der folgenden Tabelle sind Parameter für die Laminierung aufgeführt

| Nr | Name | Wert |
|---|---|---|
| 19 | Einstellung Prägekalander | Faktor 2,1 |
| 20 | Anzeige Prägekalander | 0,31 m/min |

Die Einstellung des Prägekalanders ist ein halbquantitatives Maß dafür, ob der Prägekalander an der Folienbahn eher zusätzlich zieht oder eher bremst Die folgende Tabelle zeigt Parameter für die Belichtung.

| Nr. | Name | Wert |
|---|---|---|
| 21 | Tischtemperatur | 80 °C |
| 22 | Tischneigung | 0° |
| 23 | Betriebsstunden | - |
| 24 | Leistungseinstellung der Lampe | 1000 W |

Die Tischtemperatur wird mit wassergefüllten Kammern gesteuert, die in den Tisch integriert sind. Eine mögliche Neigung des Tisches ermöglicht es, das Profil des Diffusors zu variieren Die folgende Tabelle gibt Parameter für das Flood Cure wieder

| Nr | Name | Wert |
|---|---|---|
| 27 | Betriebsstunden Flood Cure | 3357 |
| 28 | Leistungseinstellung Flood Cure | 1000 W |

In folgenden Tabelle sind Parameter für die Laminierung bzw Aufwicklung aufgeführt.

| Nr. | Name | Wert |
|---|---|---|
| 30 | Aufwickelspannung | 200 N |
| 31 | Innendurchmesser Kern für Aufwicklung | 76 mm |
| 32 | Aufwickelrichtung | Beschichtung außen |

Eine Aufwickelspannung von 200 N ist deshalb so hoch gewählt, damit die Bandspannung bei der Masterwalze ausreichend groß ist und ein Auslaufen des Rakelbehälters vermieden wird.

**6. Erhaltener Diffusor**

Aus dem Herstellungsprozess resultiert ein 50 μm dicker Diffusor auf Melinex-Folie 400. Der Diffusor mit einer Breite von 36 cm und 20 m Länge besitzt eine direkte Transmission von 8,3 % bei - 30°, 7,5% bei 30°, ca 1% bei -10° und 10°. In der Figur ist die direkte Transmission dieser PN-LLEs als Funktion des Einfallswinkels im Bereich von - 30° bis 30° dargestellt. Die direkte Transmission ($T_{direkt}$) wird wie folgt ermittelt:

$$T_{direkt} = (Haze/100) \cdot T_{Gesamt} \, [\%]$$

**Patentansprüche**

1. Verfahren zur Herstellung eines diffraktiven Lichtlenkelements, das folgende Schritte umfasst:

   a) Auftragen einer photoempfindlichen Beschichtungszusammensetzung auf eine flexible Trägerbahn,
   b) Trocknen der aufgetragenen Beschichtungszusammensetzung,
   c) Auflaminieren einer flexiblen Maske auf die getrocknete Beschichtungszusammensetzung,
   d) Belichten der Beschichtungszusammensetzung durch die Maske, um durch die mustermäßige Belichtung einen Brechzahlgradienten in der Beschichtungszusammensetzung zu erzeugen,
   e) vollflächiges Aushärten der Beschichtungszusammensetzung, um den Brechzahlgradienten zu fixieren,

   wobei die Schritte a) bis e) in dieser Reihenfolge in einem kontinuierlichen, einstufigen Rolle-zu-Rolle-Verfahren durchgeführt werden, **dadurch gekennzeichnet, dass** die photoempfindliche Beschichtungszusammensetzung einen ein- oder mehrkernigen Metallkomplex mit einem Liganden mit photochemisch polymerisierbarer Gruppe als photopolymerisierbare Komponente umfasst

2. Verfahren nach Anspruch 1, **dadurch gekennzeichnet, dass** die Maske im Rolle-zu-Rolle-Verfahren nach der Belichtung in Schritt d) und vor dem Aushärten in Schritt e) oder nach dem Schritt e) wieder abgezogen wird

3. Verfahren nach Anspruch 1 oder Anspruch 2, **dadurch gekennzeichnet, dass** die Maske einen Maskenfilm auf einer Trägerfolie umfasst

4. Verfahren nach Anspruch 3, **dadurch gekennzeichnet, dass** die Trägerfolie der Maske nach Schritt c) unter Zurücklassung des Maskenfilms auf der Beschichtungszusammensetzung wieder abgelöst wird oder die Trägerfolie von der ausgehärteten Beschichtungszusammensetzung abgelöst wird.

5. Verfahren nach einem der Ansprüche 1 bis 4, **dadurch gekennzeichnet, dass** die Beschichtungszusammensetzung bei der Belichtung in Schritt d) erwärmt wird

6. Verfahren nach einem der Ansprüche 1 bis 5, **dadurch gekennzeichnet, dass** die Beschichtungszusammensetzung in Schritt a) nur auf einen Teil der Breite der Trägerbahn aufgebracht wird, so dass das Lichtlenkelement nur auf einem Teilabschnitt der Trägerbahn gebildet wird, und das Verfahren mindestens einmal an derselben Trägerbahn wiederholt wird und bei dem oder den folgenden Durchgängen in Schritt a) die Beschichtungszusammensetzung jeweils auf einen nicht beschichteten Teil der Breite der Trägerbahn aufgebracht wird, wobei bei den zwei oder mehr Durchgängen die Beschichtungszusammensetzung vorzugsweise jeweils so aufgebracht wird, dass die gebildeten Teilabschnitte des Lichtlenkelements aneinander grenzen

7. Verfahren nach Anspruch 6, **dadurch gekennzeichnet, dass** die Beschichtungszusammensetzung die Trägerbahn so gut benetzt, dass die in einem Durchgang aufgetragene Schicht der Beschichtungszusammensetzung am Rand keilförmig verläuft, und beim nächsten oder einem folgenden Durchgang die Beschichtungszusammensetzung so aufgebracht wird, dass der Nahtbereich zum vorher aufgebrachten Teilabschnitt des Lichtlenkelements keilförmig überschichtet wird.

8. Verfahren nach einem der Ansprüche 1 bis 7, **dadurch gekennzeichnet, dass** die Breite des Lichtlenkelements mehr als 60 cm beträgt.

9. Verfahren nach einem der Ansprüche 1 bis 8, **dadurch gekennzeichnet, dass** das erhaltene Lichtlenkelement durch Übereinanderlegen mit einem oder mehreren anderen Lichtlenkelementen kombiniert wird, um einen Zwei- oder Mehrschichtverbund mit speziellen optischen Eigenschaften zu erhalten..

10. Verfahren nach einem der Ansprüche 1 bis 9, **dadurch gekennzeichnet, dass** die Beschichtungszusammensetzung die photopolymerisierbare Komponente in einem aushärtbaren Matrixmaterial umfasst, wobei das Matrixmaterial bevorzugt aus organischen Polymeren, Oligomeren oder Monomeren und/oder gegebenenfalls organisch modifizierten anorganischen Kondensaten ausgewählt ist

11. Verfahren nach einem der Ansprüche 1 bis 10, **dadurch gekennzeichnet, dass** die photopolymerisierbare Komponente eine Ti-, Zr-, Nb- oder Ta-haltige Komponente ist und/oder dass die photopolymerisierbare Komponente Vinyl oder (Meth)acryl als photopolymerisierbare Gruppe umfasst.

12. Diffraktives Lichtlenkelement, erhältlich nach einem Verfahren der Ansprüche 1 bis 11.

13. Diffraktives Lichtlenkelement nach Anspruch 12, **dadurch gekennzeichnet, dass** die Breite des Lichtlenkelements mehr als 60 cm beträgt.

14. Diffraktives Lichtlenkelement nach Anspruch 12 oder Anspruch 13, **dadurch gekennzeichnet, dass** es eine Brechzahlgradientenfolie oder ein Verbund aus Trägerbahn, Brechzahlgradientenfiolie und gegebenenfalls Abdeckfolie ist.

15. Difraktives Lichtlenkelement nach einem der Ansprüche 12 bis 14, **dadurch gekennzeichnet, dass** das Lichtlenkelement ein Verbund aus zwei oder mehr Lichtlenkelementen ist.

FIG

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5552261 A
- US 5529473 A
- WO 03058292 A

- DE 10200760 A
- EP 2005013685 W
- EP 2005013683 W